# EUROPEAN PATENT SPECIFICATION

(11) **EP 1 126 597 B1**
(45) Date of publication and mention of the grant of the patent: **20.04.2005**
(21) Application number: 01301127.5
(22) Date of filing: 08.02.2001
(51) Int. Cl.: H03F 1/32, H03F 1/52, H03F 1/30

(54) **Method of detecting a predetermined DC Offset in an automotive audio system**
Verfahren zum Ermitteln eines vorbestimmten Gleichspannungsoffsets in einem Audiosystem für Kraftfahrzeuge
Méthode pour la détection d'un décalage de niveau continu prédéterminé dans un système audio pour automobile

(30) Priority: 17.02.2000 US 505305
(43) Date of publication of application: 22.08.2001
(73) Proprietor: Visteon Global Technologies, Inc., Dearborn, Michigan 48126-2490 (US)
(72) Inventor: Krochmal, Andrew Cyril, Plymouth, MI 48170 (US); Hamel, Gregory Roger, Livonia, MI 48152 (US); Whitecar, John Elliot, Plymouth, MI 48170 (US)
(74) Representative: McLean, Robert Andreas

(56) References cited:
- US-A- 4 184 187
- US-A- 5 255 324
- PATENT ABSTRACTS OF JAPAN vol. 2000, no. 08, 6 October 2000 (2000-10-06) & JP 2000 152367 A (FMS AUDIO SDN BHD), 30 May 2000 (2000-05-30)

## Description

### BACKGROUND

The present invention relates in general to detecting a DC offset in an automotive audio system, and, more specifically, to use of a diagnostic signal from a power amplifier to determine output conditions of the power amplifier as they are affected by a DC offset.

Automotive audio systems typically have a power amplifier intended to amplify AC signals, but which will amplify any signal which is presented at the amplifier's input. Audio speakers, (normally 4 ohms), which are attached to the amplifier can be damaged by certain amounts of DC current. Capacitors are normally used on an input side of the amplifier to remove any DC offset in the amplifier input signal, thereby preventing DC current from flowing to the speakers. In the event these capacitors fail or are inadvertently not present, there can be substantial damage caused to the amplifier and/or the speakers. Currently, most automotive power amplifiers have protection for shorts but not for DC offsets.

### SUMMARY OF THE INVENTION

The present invention overcomes the deficiencies of the prior art by providing automatic detection of a DC offset.

In one aspect, the method detects a predetermined DC offset in an audio signal provided by an audio processor unit to an audio power amplifier, wherein the audio amplifier provides a clip detect signal back to the audio processor unit. The method begins by sampling the clip detect signal at a predetermined rate during a predetermined time interval to collect a predetermined number of samples. Then, a number of active clip detects are counted during the predetermined time interval. Next, the counted number is compared to a predetermined threshold and the predetermined DC offset is detected if the counted number exceeds the predetermined threshold.

### BRIEF DESCRIPTION OF THE DRAWINGS

The invention will now be described in further detail, by way of example with reference to the accompanying drawings, in which:
Figure 1 is a block diagram showing the audio system of the present invention.
Figure 2 is a block diagram showing portions of the audio system in an alternate embodiment.
Figure 3 is a flowchart showing the operation of the present invention.

### DETAILED DESCRIPTION OF PREFERRED EMBODIMENTS

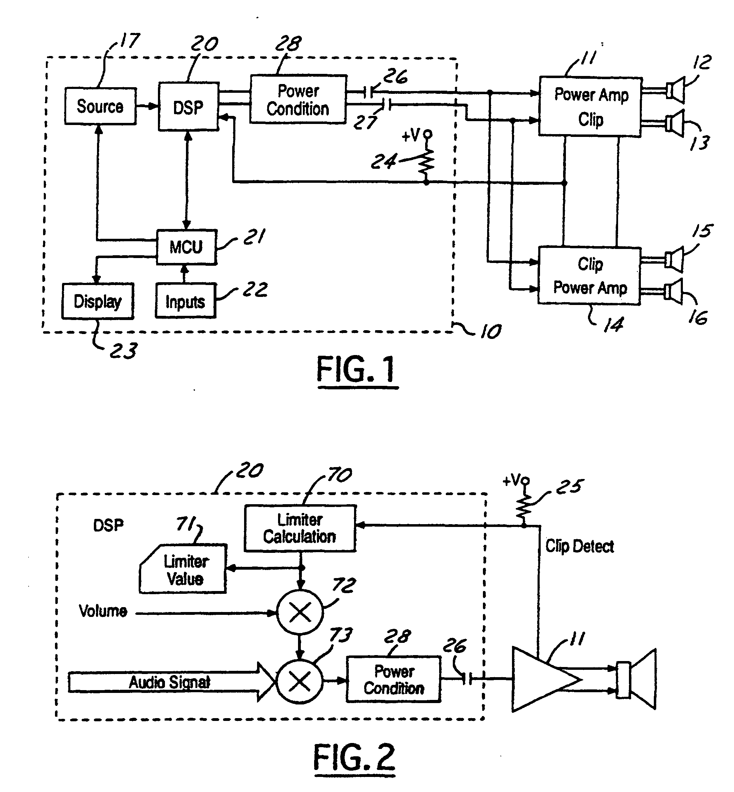

Figure 1 shows an automotive audio system including an audio processing unit or head unit 10 and power amplifiers 11 and 14 driving speakers 12, 13, 15 and 16. Power amps 11 and 14 each drive left and right stereo speakers for front and rear speakers sets, respectively.

Processing unit 10 includes an audio source 17 such as a radio tuner, cassette player, or compact disc player. An audio signal from source 17 is provided to an input of a digital signal processor (DSP) 20 which outputs left and right stereo signals. Capacitors 26 and 27 are located between a power condition circuit 28 and power amplifier 14 and 11. Power conditioning circuit 28 includes digital-to-analog converter circuits for converting the DSP output to an analog signal. The capacitors allow AC signals to flow while preventing any DC signal flow, thus preventing DC offset in the amplified signals. In the event these capacitors are shorted, damaged, or missing, the speakers will be subjected to DC current which could potentially cause damage.

A microcontroller unit (MCU) 21 communicates with DSP 20 and source 17 to control operation of the audio system. MCU 21 receives input commands from inputs 22 which may include push button operator controls or an interface to a multiplex network whereby commands may be received from other locations. A display 23 is connected to MCU 21 for displaying status of the audio processing unit to allow adjustment of audio parameters such as volume, balance, and fade.

Power amps 11 and 14 provide outputs from a clip detector. The clip detector outputs indicate moments when clipping occurs in the output signal of the respective power amplifiers. The clip detect outputs of power amps 11 and 14 are connected together and to a pull-up resistor 24 and an input of DSP 20 in audio processing unit 10. The clip detect outputs of power amp 11 and 14 are configured to provide a current sink(i.e., a direct connection to ground) when clipping occurs. Thus, the occurrence of clipping pulls the voltage at resistor 24 to ground, whereas the junction is at a high voltage from voltage supply +V when clipping is not occurring.

Figure 2 shows a DSP limiter function in which signal level is reduced in response to clipping. A clip detect signal provided from power amp 11 in conjunction with a pull-up resistor 25 is input to DSP 20 and is used in a limiter calculation which relates the severity of clipping with a particular limiter value. Specifically, the limiter value is reduced from a maximum value of 1.0 to a possible minimum value of 0.1 at a predetermined attack rate during clipping and is restored toward 1.0 at a slower decay rate when clipping is not present. Thus, a limiter calculation 70 produces a limiter value 71 which is stored in DSP 20 and is provided as a multiplier input to a multiplier 72 to reduce the volume command. The output of multiplier 72 is provided to a multiplier 73 which multiplies the audio signal which is then provided to power amplifier 11.

The present invention analyzes clipping to determine if a DC offset is present. The clip detect outputs are monitored for active states during normal operation. Software routines, for example, in DSP 20 utilize a timer and a counter to sample and count a number of active clip detects occurring during a predetermined time interval. A hardware/analog circuit counter and timer can also be used to monitor the clip detect outputs. A predetermined rate is used to determine when to sample the clip detect output. The predetermined rate can be a cycle time of MCU 21, such as every 26 microseconds, for example. If the clip detect output is active when a sample is taken then the counter is incremented. Accumulation of a predetermined number of samples, such as 1000, is used to determine when to compare the counter to a predetermined threshold. A predetermined time interval is determined by a minimum frequency that can produce clipping. If the predetermined rate is 26 microseconds then a predetermined time interval for 1000 samples will be 1000•26•10⁻⁶ or 26 milliseconds. This equals about 38 Hz and is the lowest frequency that will be detected if and when it causes clipping.

The predetermined threshold can vary depending on the characteristics of the amplifier and the clip detect.

Values from about 30 percent to about 50 percent of the total number of samples has been found to uniquely identify presence of a DC offset, for example. These values are typical because a normal signal without DC offset can clip based on the nature of audio signals and a maximum output of the audio amplifier. A normal clipping rate is about 10 to 15 percent. Any clipping rate above the normal clipping rate is considered unusual and indicates a DC offset.

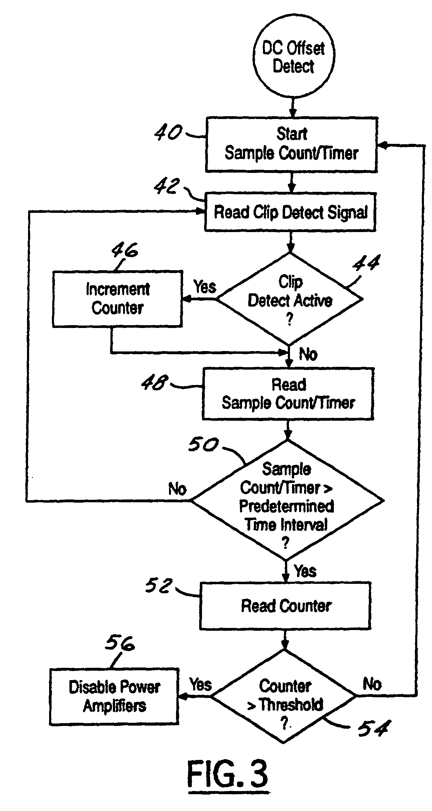

Figure 3 shows a method of detecting a DC offset in an audio power amplifier. In step 40 a sample count/timer is started. In step 42 a clip detect signal is sampled. Next, if the clip detect is active in step 44, a counter is incremented in step 46. If the clip detect is not active in step 44 or after the counter is incremented in step 46 the timer is read in step 48. If the timer has not exceeded a predetermined timer interval in step 50 then steps 42-50 are repeated until the timer exceeds the predetermined time interval. After the timer exceeds the predetermined time interval the counter is read in step 52. In step 54, the counter reading is compared to a predetermined threshold and if the counter reading exceeds the predetermined threshold then the power amplifier is disabled in step 56 else the method is repeated starting at step 40.

## Claims

1. A method of detecting a DC offset in an audio signal provided by an audio processing unit to an audio power amplifier, wherein said audio amplifier provides a clip detect signal back to said audio processing unit, wherein said method comprising the steps of:
sampling said clip detect signal at a predetermined rate during a predetermined time interval to collect a predetermined number of samples;
counting a number of active clip detects during said predetermined time interval;
comparing said counted number to a predetermined threshold; and
identifying the presence of said DC offset if said counted number exceeds said predetermined threshold.

2. The method according to Claim 1, wherein said audio processing unit comprises a microprocessor and wherein said predetermined rate corresponds to at least one cycle of said microprocessor.

3. The method according to Claim 1, wherein said predetermined threshold is at least 30 percent of said predetermined number of samples.

4. The method according to Claim 1, wherein if said counted number exceeds said predetermined threshold, then a fault is reported to said head unit.

5. The method according to Claim 1, wherein said predetermined time interval is at least as big as a period corresponding to a lowest frequency amplified by said audio power amplifier.

6. The method according to Claim 1, wherein said predetermined threshold is between about 300 and about 500 active clip counts out of a possible 1000 active clip counts.

7. The method according to Claim 1, wherein if said counted number exceeds said predetermined threshold then said audio power amplifier is shut down.

8. A system for detecting a DC offset in an audio signal provided by an audio processing unit to an audio amplifier, wherein said audio amplifier provides a clip detect signal back to said audio processing unit, wherein said system comprises:
a timer to sample said clip detect within a predetermined time interval until a predetermined number of samples is reached;
a counter counting active clip detects; and
a comparator comparing said counted active clip detects with a predetermined threshold when said predetermined number of samples is reached;
wherein if said counter exceeds said predetermined threshold then the presence of said DC offset is identified.

## Patentansprüche

1. Verfahren für das Erkennen eines Gleichstrom-Offsets bei einem Audiosignal, das von einer Audioverarbeitungseinheit für einen Audioleistungsverstärker bereitgestellt wird, wobei der Audioverstärker ein Spitzen- oder Übersteuerungserkennungssignal an die Audioverarbeitungseinheit zurück schickt und das Verfahren folgende Schritte umfasst:
Abtasten des Spitzen- oder Übersteuerungserkennungssignals mit einer vorbestimmten Rate im Verlauf eines vorbestimmten Zeitintervalls, um eine vorbestimmte Anzahl von Abtastwerten zu sammeln,
Zählen einer Anzahl von aktiven Spitzen- oder Übersteuerungserkennungen im Verlauf des vorbestimmten Zeitintervalls,
Vergleichen der gezählten Anzahl mit einem vorbestimmten Schwellwert und
Ermitteln des Vorliegens des Gleichstrom-Offsets, wenn die gezählte Anzahl den Schwellwert übersteigt.

2. Verfahren nach Anspruch 1, bei dem die Audioverarbeitungseinheit einen Mikroprozessor umfasst und die vorbestimmte Rate mindestens einem Zyklus des Mikroprozessors entspricht.

3. Verfahren nach Anspruch 1, bei dem der vorbestimmte Schwellwert mindestens 30 Prozent der vorbestimmten Anzahl von Abtastwerten entspricht.

4. Verfahren nach Anspruch 1, bei dem der Haupteinheit ein Fehler gemeldet wird, wenn die gezählte Anzahl den vorbestimmten Schwellwert übersteigt.

5. Verfahren nach Anspruch 1, bei dem das vorbestimmte Zeitintervall mindestens so groß ist wie eine Periodendauer, die einer niedrigsten Frequenz entspricht, die vom Audioleistungsverstärker verstärkt wird.

6. Verfahren nach Anspruch 1, bei dem der vorbestimmte Schwellwert zwischen etwa 300 und etwa 500 aktiven Spitzen- oder Übersteuerungszählungen aus 1000 möglichen aktiven Übersteuerungszählungen liegt.

7. Verfahren nach Anspruch 1, bei dem der Audioleistungsverstärker abgeschaltet wird, wenn die gezählte Anzahl den vorbestimmten Schwellwert übersteigt.

8. System für das Erkennen eines Gleichstrom-Offsets bei einem Audiosignal, das von einer Audioverarbeitungseinheit für einen Audioverstärker bereitgestellt wird, wobei der Audioverstärker ein Spitzen- oder Übersteuerungserkennungssignal an die Audioverarbeitungseinheit zurück schickt und das System folgendes umfasst:
einen Zeitgeber für das Abtasten der Spitzen- oder Übersteuerungserkennung innerhalb eines vorbestimmten Zeitintervalls, bis eine vorbestimmte Anzahl von Abtastwerten erreicht erreicht wird,
einen Zähler, der aktive Spitzen- oder Übersteuerungserkennungen zählt, und
einen Komparator, der die gezählten aktiven Übersteuerungserkennungen mit einem vorbestimmten Schwellwert vergleicht, wenn die vorbestimmte Anzahl von Abtastwerten erreicht wird,
wobei das Vorliegen des Gleichstrom-Offsets festgestellt wird, wenn die gezählte Anzahl den Schwellwert übersteigt.

## Revendications

1. Une méthode pour détecter un décalage de courant continu dans un signal audio fourni par un circuit de traitement des signaux sonores à un amplificateur de puissance audio, dans laquelle ledit amplificateur audio fournit un signal de détection de crêtes ou d'écrêtage en retour audit circuit de traitement des signaux sonores, ladite méthode comprenant les étapes de :
échantillonner ledit signal de détection d'écrêtage ou de crêtes selon un taux prédéterminé pendant un intervalle de temps prédéterminé pour collecter un nombre d'échantillons prédéterminé ;
compter un nombre de détections actives de crêtes ou d'écrêtage pendant ledit intervalle de temps prédéterminé ;
comparer ledit nombre compté avec une limite prédéterminée ; et
identifier la présence dudit décalage de courant continu si ledit nombre compté dépasse ladite limite prédéterminée.

2. La méthode selon la revendication 1, dans laquelle ledit circuit de traitement des signaux sonores comprend un microprocesseur et dans laquelle ledit taux prédéterminé correspond à au moins un cycle de la cadence dudit microprocesseur.

3. La méthode selon la revendication 1, dans laquelle ladite limite prédéterminée est d'au moins 30 % dudit nombre d'échantillons prédéterminé.

4. La méthode selon la revendication 1, dans laquelle une faute est rapportée à ladite installation principale si ledit nombre compté dépasse ladite limite prédéterminée.

5. La méthode selon la revendication 1, dans laquelle ledit intervalle de temps prédéterminé est au moins aussi important qu'une période correspondant à une fréquence la moins élevée amplifiée par ledit amplificateur de puissance audio.

6. La méthode selon la revendication 1, dans laquelle ladite limite prédéterminée est comprise entre environ 300 et environ 500 instances actives d'écrêtage ou crêtes effectives, parmi 1000 instances actives d'écrêtage ou crêtes effectives possibles.

7. La méthode selon la revendication 1, dans laquelle ledit amplificateur de puissance audio est mis hors - service si ledit nombre compté dépasse ladite limite prédéterminée.

8. Un système pour détecter un décalage de courant continu dans un signal audio fourni par un circuit de traitement des signaux sonores à un amplificateur audio, dans lequel ledit amplificateur audio fournit un signal de détection d'écrêtage ou de crêtes en retour audit circuit de traitement des signaux sonores, ledit système comprenant :
un chronomètre pour échantillonner ladite détection d'écrêtage ou de crêtes dans un intervalle de temps prédéterminé jusqu'à ce qu'un nombre d'échantillons prédéterminé soit atteint ;
un compteur comptant les détections actives d'écrêtage ou de crêtes ; et
un comparateur comparant lesdites détections actives d'écrêtage ou de crêtes comptées avec une limite prédéterminée lorsque ledit nombre d'échantillons prédéterminé est atteint ;
dans lequel la présence dudit décalage de courant continu est identifiée si ledit compteur excède ladite limite prédéterminée.
